Europäisches Patentamt

European Patent Office

Office européen des brevets

(19)

(11) Veröffentlichungsnummer: **0 280 304**
**A2**

(12) **EUROPÄISCHE PATENTANMELDUNG**

(21) Anmeldenummer: 88102834.4

(22) Anmeldetag: 25.02.88

(51) Int. Cl.4: **H01S 3/23** , H01S 3/19

(30) Priorität: 27.02.87 DE 3706477

(43) Veröffentlichungstag der Anmeldung:
31.08.88 Patentblatt 88/35

(84) Benannte Vertragsstaaten:
DE FR GB IT

(71) Anmelder: Siemens Aktiengesellschaft Berlin
und München
Wittelsbacherplatz 2
D-8000 München 2(DE)

(72) Erfinder: Heinen, Jochen, Dr.
Dianastrasse 38
D-8013 Haar(DE)

(54) **Halbleiterlaseranordnung.**

(57) Halbleiterlaseranordnung mit mindestens zwei laseraktiven Streifen (11;12) mit getrennter elektrischer Kontaktierung (5) und Index-oder Quasiindexführung, wobei mindestens einmal die laterale Eingrenzung der Strahlung auf eine zu den laseraktiven Streifen parallele Länge derart aufgehoben ist, daß eine Verkopplung zwischen den Laserstreifen bewirkt ist.

FIG 2

FIG 3

EP 0 280 304 A2

## Halbleiterlaseranordnung

Die Erfindung betrifft eine Halbleiterlaseranordnung mit lateraler Verkopplung zwischen mindestens zwei getrennt ansteuerbaren laseraktiven Streifen.

Das Arbeitsprinzip des Lasers beruht im wesentlichen darauf, daß die in einem aktiven Bereich erzeugte Strahlung durch Resonanz für gewisse Frequenzen verstärkt wird. Die Oberflächen an den Enden der zumeist streifenförmig ausgebildeten laseraktiven Bereiche wirken als halbdurchlässige Spiegel. Wenn die Längenausdehnung dieses aktiven Bereiches einer ganzen Anzahl von Wellenlängen entspricht, tritt Resonanz auf. Eine Einfrequenz-Laserdiode kann z.B. dadurch hergestellt werden, daß statt nur eines laseraktiven Bereiches deren mehrere vorhanden sind, die untereinander verkoppelt werden.

Eine verkoppelte Laserdiodenanordnung ist zum Beispiel in der US-PS 46 20 307 beschrieben. Bei diesem Aufbau ist ein laseraktiver Streifen vorhanden, dem mindestens ein weiterer gleichartig aufgebauter Streifen von variabler Länge zugeordnet ist, wobei der bzw. die zugeordneten Streifen derart mit Strom gespeist werden, daß eine Anregung eigener Laserstrahlung unterbleibt. Diese unterhalb der Anregungsschwelle betriebenen Laserstreifen sind durch die benachbarte Anordnung zu dem aktiven Laserstreifen mit diesem lateral verkoppelt. Das Maß der Kopplung kann durch den Abstand der Laserstreifen und die Längenabmessung, über die hinweg diese Kopplung wirksam ist, bestimmt werden. Bei dieser Anordnung sind der aktive und die zugeordneten Laserstreifen gesondert mit elektrischen Kontakten versehen. Sie können also getrennt angesteuert werden. Die Herstellung der in dieser Anordnung für die Ausbildung der Stirnflächen der laseraktiven Bereiche in die Oberfläche des Halbleiterkörpers hineinreichenden Gruben, setzen einen Mindestabstand zwischen den Laserstreifen voraus, der so groß ist, daß eine Verkopplung dieser Laserstreifen nur gewährleistet ist, wenn die in dem aktiven Streifen erzeugte Strahlung nicht zu stark seitlich lokalisiert ist. Eine typische Anwendung einer solchen Anordnung ist daher die Verkopplung von gewinngeführten Lasern.

In der europäischen Patentanmeldung Nr. 0161924 ist ein Halbleiterlaserarray beschrieben, bei dem eine Vielzahl von indexgeführten Laserstreifen untereinander verkoppelt sind. Der Zweck dieses Aufbaues ist, die verschiedenen laseraktiven Streifen untereinander ohne Phasenverschiebung zu koppeln. Die aktive Schicht, die Schichten der Laserstreifen und die Schichten der Koppelbereiche bestehen jeweils aus GaAlAs unterschiedlicher Zusammensetzung und Dotierung. Alle Laserstreifen sind gleich lang und über ihre gesamte Länge miteinander verkoppelt. Getrennte Ansteuerung der Laser erfolgt nicht; es ist nur eine gemeinsame positive Elektrode und eine gemeinsame negative Elektrode vorgesehen. Aufgrund von Aufbau und Material unterscheiden sich bei diesem Aufbau die Laserstreifen von den Koppelstreifen grundlegend. Andererseits ist die strahlungserzeugende aktive Schicht durchgehend ausgebildet.

In J. Ohsawa e.a.: "A Dual-Stripe Phase-Locked Diode Laser", Jap. J. Appl. Phys. 22, L 230 bis L 232 (1983) ist ein Aufbau beschrieben, bei dem zwei BH-Laser in einem Bauelement integriert sind. Die jeweiligen aktiven Schichten sind voneinander getrennt; es ist keine Verkopplung über die aktiven Sichten vorgesehen. Wie in der vorgenannten Druckschrift werden auch hier beide Laser über gemeinsame Elektroden gleichzeitig angesteuert.

Die Verkopplung verschiedener Halbleiterlaserstreifen läßt sich bei gewinngeführten Lasern dadurch erreichen, daß die aktiven Streifen in hinreichend kleinen seitlichen Abständen zueinander angeordnet werden. Wenn verschiedene laseraktive Streifen mit spiegelnden Endflächen zum Beispiel durch Ausätzen von Gruben versehen werden sollen und die einzelnen Streifen getrennt mit elektrischer Kontaktierung belegt werden sollen, müssen Mindestabstände zwischen diesen Laserstreifen eingehalten werden. Bei gewinngeführten Lasern genügt dieser minimale Abstand für eine ausreichende Verkopplung. Bei indexgeführten Lasern wie BH-Lasern sind die laseraktiven Streifen ganz von Halbleitermaterial mit relativ zum Streifen niedrigerem Brechungsindex umgeben. Bei quasiindexgeführten Lasern wie MCRW-Lasern wird durch eine Metallschicht auf der Oberfläche für die Strahlung in der aktiven Schicht die Wirkung eines umgebenden Materials mit variablem Brechungsindex erzielt. Bei diesen index-oder quasiindexgeführten Lasern klingen die Feldintensitäten außerhalb der aktiven Schicht sehr rasch ab, so daß bei den minimalen herstellbaren Abständen der aktiven Streifen keine Verkopplung möglich ist. Eine im Prinzip denkbare Verfeinerung der Herstellungstechnik, die auch eine getrennte elektrische Kontaktierung der Laserstreifen ermöglichen würde, könnte keine sinnvolle Verkopplung schaffen, weil bei diesen Lasertypen für eine laterale Verkopplung Abstände nötig wären, die bereits in der Größenordnung der zu emittierenden Lichtwellenlänge liegen, was dazu führt, daß das Laserdiodenarray nurmehr wie ein einzelner Resonator wirkt.

Aufgabe der vorliegenden Erfindung ist es, einen Aufbau für eine Halbleiterlaseranordnung mit einer engen Lokalisierung der Strahlungsfeldintensitäten auf die aktiven Bereiche anzugeben, so daß diese aktiven Bereiche einen für Zwecke der Frequenzselektion und getrennte Ansteuerbarkeit hinreichend großen Abstand haben und gleichzeitig eine optische Verkopplung zwischen den aktiven Bereichen erzielt ist.

Diese Aufgabe wird bei einer erfindungsgemäßen Anordnung durch die Merkmale des Anspruchs 1 gelöst.

Bei der Erfindung liegt Verkopplung der laseraktiven Streifen auf einem oder mehreren Anteilen ihrer Gesamtlänge vor. Diese Verkopplung wird dadurch bewirkt, daß die die Eingrenzung der Strahlungserzeugung bewirkenden streifenförmigen Bereiche in H-förmiger Weise durch querverlaufende Streifen aus gleichartigem Halbleitermaterial überbrückt sind. Die Begrenzungen dieser querverlaufenden Streifen oder Stege in den verkoppelten Bereichen können in beliebigem Winkel zu den Laserstreifen verlaufen. Die physikalischen Eigenschaften der Laseranordnung sind in diesen verkoppelten Bereichen mit denen von verkoppelten gewinngeführten Lasern vergleichbar. Die Länge dieser verkoppelten Bereiche ist so gewählt, daß keine merkliche Störung der Strahlungserzeugung auftritt. Zu diesem Zweck können auch mehrere kurze verkoppelte Bereiche über die gesamte Laserlänge verteilt sein. Die Stärke der Verkopplung ist über die jeweiligen Längen dieser verkoppelten Bereiche und den oder die Abstände der einzelnen Laserstreifen untereinander sowie deren jeweilige Längen und Breiten einstellbar. Über eine Variation der verschiedenen Laserlängen und -breiten, deren Abstände und die Längen der Koppelbereiche können so verschiedene Resonanzeigenschaften erzielt werden. Auf diese Weise läßt sich stabile einfrequente Strahlung erzeugen, indem durch die Verkopplung verschiedenartiger Laser nur eine longitudinale Grundschwingung in Resonanz verstärkt wird. Die getrennte elektrische Kontaktierung erlaubt eine Variation der Lichtausbreitung in den verschiedenen Laserstreifen und ermöglicht insbesondere eine Modulation der Lichtintensität, wobei der oder die lateral angekoppelten Laser im Gleichstrom betrieben werden und zur Stabilisierung und Frequenzselektion angekoppelte Oszillatoren darstellen.

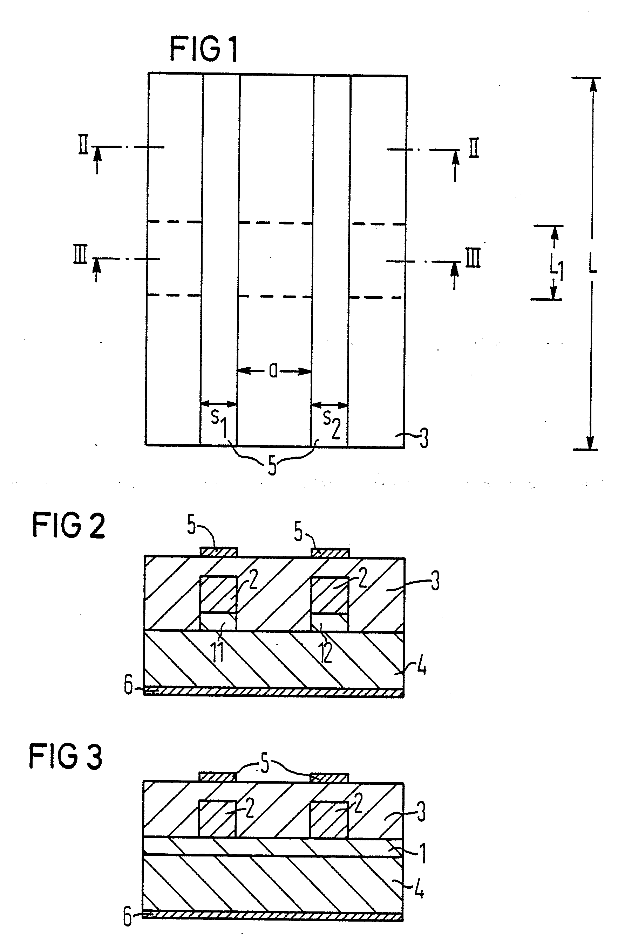

Ausführungsbeispiele für einen BH-Laser und MCRW-Laser werden anhand der Figuren 1 bis 6 beschrieben.

Figur 1 zeigt einen erfindungsgemäßen BH-Laser in Aufsicht.

Figur 2 zeigt eine erfindungsgemäßen BH-Laser nach Figur 1 in einem auf der markierten Höhe II angebrachten Schnitt.

Figur 3 zeigt einen erfindungsgemäßen BH-Laser nach Figur 1 in einem auf der Höhe III angebrachten Schnitt.

Figur 4 zeigt einen erfindungsgemäßen MCRW-Laser in der Aufsicht.

Figur 5 zeigt einen erfindungsgemäßen MCRW-Laser nach Figur 4 in einem auf der markierten Höhe V angebrachten Schnitt.

Figur 6 zeigt einen erfindungsgemäßen MCRW-Laser nach Figur 4 in einem auf der markierten Höhe VI angebrachten Schnitt.

Figur 7 zeigt eine abweichende Ausgestaltung eines erfindungsgemäßen MCRW-Lasers in einem Figur 5 entsprechenden Schnitt.

Figur 8 zeigt eine abweichende Ausgestaltung eines erfindungsgemäßen MCRW-Lasers in einem Figur 6 entsprechenden Schnitt.

Ein erfindungsgemäßer BH-Laser ist beispielsweise wie folgt aufgebaut.

Auf einem Trägersubstrat 4 aus n-leitend dotiertem Halbleitermaterial befindet sich eine p-leitend dotierte Schicht 3. In Aussparungen dieser p-leitend dotierten Schicht 3 sind aktive Streifen 11, 12 ausgebildet und darüber streifenförmige Bereiche 2, die starke p-leitend dotiert sind. Die p-leitend dotierte Schicht 3 und die stark p-leitend dotierten Bereiche 2 sowie das Trägersubstrat 4 bestehen aus InP. Die aktiven Streifen 11, 12 bestehen aus InGaAsP; in ihnen wird die Strahlung erzeugt und durch Resonanz verstärkt. In einem verkoppelten Bereich der Koppellänge L, ist zwischen den aktiven Streifen 11, 12 in diesem Verbindung aus InGaAsP, die z.B. dadurch hergestellt ist, daß beim Herausätzen der aktiven Streifen 11 und 12 in diesem Bereich der Koppellänge L, zwischen den Streifen 11 und 12 das InGaAsP-Material stehengelassen wurde. Die darüberbefindlichen stark p-leitend dotierten Bereiche sind in jedem Fall streifenförmig und ohne Verbindung ausgebildet. Ein erster Kontakt 6 für die negative Elektrode ist ganzflächig auf der freien Seite des Trägersubstrates 4 aufgebracht. Weitere Kontakte 5 für die positiven Elektroden sind streifenförmig über den stark p-leitend dotierten Bereichen auf der Oberseite der p-leitend dotierten Schicht 3 angebracht.

Beim MCRW-Laser begegnet uns ein Prinzip gleicher Aufbau. Auf einem Trägersubstrat 4 aus InP, das auf der einen Seite mit einem ersten Kontakt 6 für die negative Elektrode versehen ist, ist eine InGaAsP-Schicht als Laserschicht 16, in der sich die laseraktiven Streifen 11, 12 befinden und die im übrigen als Wellenlieter dient, aufgebracht, die nach oben durch eine p-leitend dotierte Schicht 3 abgedeckt ist. Diese p-leitend dotierte Schicht 3 und das Trägersubstrat 4 sind aus InP-Material. Die laseraktiven Streifen 11, 12 sind dadurch ausgebildet, daß die p-leitend dotierte Schicht 3 in der Weise ausgespart ist, daß in Längsrichtung verlaufende Stege 13, 14 stehenbleiben. Diese Stege 13, 14 sind auf der Oberseite mit weiteren Kontakten 5 für die positiven Elektroden versehen. Die tieferliegenden Bereiche der Oberfläche der p-leitend dotierten Schicht 3 sind ebenfalls mit einer Metallbelegung 31 versehen. Die Verkopplung zwischen den laseraktiven Streifen 11, 12, die sich unter den Stegen 13, 14 ausbilden, geschieht in der Weise, daß jeweils auf eine vorgegebene Koppellänge $L_2$, $L_3$ das Halbleitermaterial der p-leitend dotierten Schicht 3 zwischen den Stegen 13, 14 nicht vollständig ausgespart ist, sondern in einer gewissen Höhe, in der Regel auf der Höhe der Stege 13, 14, stehenbleibt und so eine H-förmige Struktur bildet. Die auf diese Weise zwischen den Stegen 13, 14 ausgebildeten Stege aus Halbleitermaterial mit der Dicke der jeweiligen Koppellänge $L_2$, $L_3$ werden im folgenden als Querstege 15 bezeichnet.

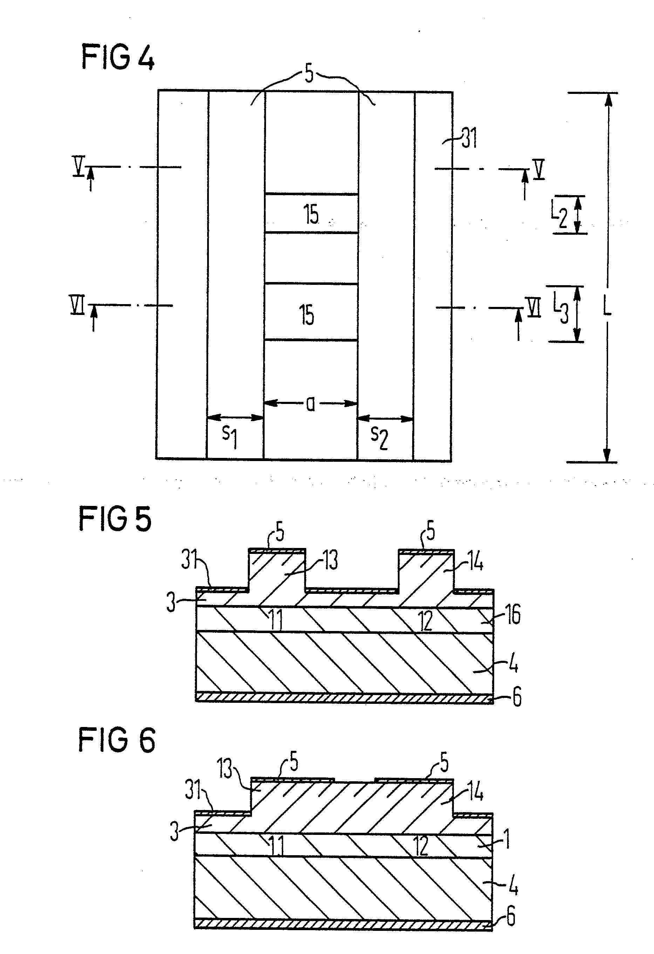

Um eine möglichst gute Verkopplung zu erzielen, ist es vorteilhaft, die Laserschicht 16 auch unter den Querstegen 15 zu pumpen. Damit zu diesem Zweck durch die Querstege ein hinreichend hoher Strom fließt, ist in den vorliegendem Ausführungsbeispiel, wie in Figur 6 dargestellt, die Metallschicht der weiteren Kontakte 5 jeweils bis auf den Quersteg 15 ausgebildet, wobei etwa in der Mitte zwischen den durch den betreffenden Quersteg 15 verbundenen Stegen 13, 14 die Metallschicht dieser weiteren Kontakte 5 längs eines schmalen zu den Stegen 13, 14 parallelen Streifens unterbrochen und so die getrennte Ansteuerbarkeit der zu den Stegen 13, 14 gehörenden aktiven Streifen 11, 12 gewährleistet ist.

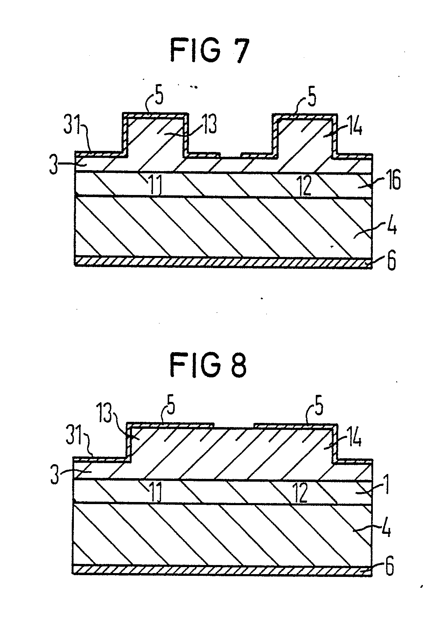

Die weiteren Kontakte 5 für die positiven Elektroden können mit der Metallbelegung 31 eine zusammenhängende Metallschicht bil den. In diesem Fall sind die Seiten der Stege 13, 14 ebenfalls mit Metall bedeckt, wie in Figur 7 dargestellt.

Figur 8 zeigt den entsprechenden Aufbau im Bereich eines Quersteges 15. Um auch bei dieser Ausführungsvariante eine getrennte Kontaktierung der Stege 13, 14 zu ermöglichen, ist die aus den weiteren Kontakten 5 und der Metallbelegung 31 gebildete Metallschicht auf einem zwischen den Stegen 13, 14 und zu diesen parallel über ihre gesamte Länge verlaufenden Streifen unterbrochen.

Damit zwischen dem Halbleitermaterial der dotierten Schicht 3 und den darauf für die positiven Elektroden aufgebrachten Metall ein hinreichend leitender Übergang ausgebildet worden sein kann und die weiteren Kontakte 5 mithin ohmsche Kontakte darstellen, ist die dotierte Schicht 3 in unter den weiteren Kontakten 5 liegenden oberen Bereichen der Stege 13, 14 und Querstege 15 stark p-leitend dotiert (in den Figuren 5 bis 8 durch die Schraffur angedeutet), oder es ist eine stark dotierte weitere Schicht aus demselben oder einem anderen Halbleitermaterial zwischen den Stegen 13, 14 oder Querstegen 15 und den weiteren Kontakten 5 ausgebildet.

Bei beiden beschriebenen Lasertypen kann durch eine Veränderung der Länge L, der jeweiligen Breiten der aktiven Streifen $s_1$ und $s_2$, des relativen Abstandes a und der Koppellängen $L_1, L_2, L_3$ eine Variation der Resonatoreigenschaften im Hinblick auf zu erzielende Eigenschaften vorgenommen werden. Ebenso ist es denkbar, daß nicht zwei, sondern mehrere laseraktive Streifen vorhanden sind. Darüberhinaus ist die Länge L nicht für alle Laserstreifen verbindlich; vielmehr können die einzelnen laseraktiven Streifen unterschiedliche Längen aufweisen. In dem Fall sind die reflektierenden Enden durch Aus-bzw. Abätzen des daran anschließenden Halbleitermaterials gebildet. Ebenso können mehrere Koppelbereiche verschiedener Länge ausgebildet sein. Durch die getrennte Kontaktierung der verschiedenen laseraktiven Streifen ist eine getrennte elektrische Ansteuerung derselben möglich. Auf diese Weise läßt sich die Frequenz modulieren bzw. durch eine unterschiedlich starke Stromstärke die Ausbreitungsgeschwindigkeit des Lichtes in den verschiedenen Streifen variieren.

## Ansprüche

1. Halbleiterlaseranordnung mit mindestens zwei laseraktiven Streifen (11,12) auf einem Trägersubstrat (4) aus dotiertem Halbleitermaterial des ersten Leitungstyps, wobei ein erster Kontakt (6) für eine Elektrode auf der freien Seite des Trägersubstrates (4) und getrennte weitere Kontakte (5) für Elektroden zur getrennten Ansteuerung der laseraktiven Streifen (11,12) vorgesehen sind und eine Führung der in den laseraktiven Streifen (11,12) erzeugten Strahlung durch die Höhe des Brechungsindexes der laseraktiven Streifen (11.12) und der Brechungsindizes und gegebenenfalls der Dicke der sie umgebenden Materialien (2,3,4) bewirkt ist,
**dadurch gekennzeichnet,**
daß zwischen den laseraktiven Streifen (11,12) mindestens einmal die durch diese Führung bewirkte laterale Eingrenzung der Strahlung auf eine jeweils so zu bemessende zu den laseraktiven Streifen (11,12) parallele Länge $(L_1, L_2, L_3)$ aufgehoben ist, daß eine insgesamt vorgegebene laterale Verkopplung zwischen den laseraktiven Streifen (11,12) bewirkt ist.

2. Halbleiterlaser nach Anspruch 1, wobei die laseraktiven Streifen (11,12) seitlich und von oben in eine dotierte aufgewachsene Schicht (3) des zweiten Leitungstyps eingebettet sind, wobei den laseraktiven Streifen (11, 12) gegenüberliegend auf der Oberfläche der aufgewachsenen Schicht (3) streifenförmig die getrennten weiteren Kontakte (5) aufgebracht sind (BH-Laser; Figuren 1 bis 3),

**dadurch gekennzeichnet,**

daß die Aufhebung der lateralen Eingrenzung der Strahlung jeweils durch eine die laseraktiven Streifen überbrückende Koppelschicht (1) aus dem gleichen Halbleitermaterial, aus dem die laseraktiven Streifen (11,12) bestehen, bewirkt ist.

3. Halbleiterlaser nach Anspruch 1, wobei auf dem Trägersubstrat (4) eine Laserschicht (16) und eine dotierte Schicht (3) mit darin ausgebildeten Stegen (13,14) die auf der Oberseite mit den getrennten weiteren Kontakten (5) versehen sind, aufgewachsen sind und diese dotierte Schicht (3) außerhalb des von den Stegen (13,14) eingenommenen Bereiches mit Metallbelegung (31) versehen ist, was für die sich in der Laserschicht (16) ausbreitenden Strahlung wie eine Absenkung des Brechungsindexes des umgebenden Materials wirkt und die in laseraktiven Streifen (11,12) der Laserschicht (1) erzeugte Strahlung auf streifenförmige Bereiche unterhalb der Stege (13,14) eingrenzt (MCRW-Laser; Figuren 4 bis 6)

**dadurch gekennzeichnet,**

daß die laterale Eingrenzung der Strahlung dadurch aufgehoben ist, daß das Halbleitermaterial der dotierten Schicht (3) zwischen den Stegen (13,14) jeweils einen Quersteg (15) bildet.

4. Halbleiterlaser nach Anspruch 3,

**dadurch gekennzeichnet,**

daß die weiteren Kontakte (5) jeweils bis auf einen Teil der Querstege (15) ausgebildet sind (Figur 6).

5. Halbleiterlaser nach Anspruch 3 oder 4,

**dadurch gekennzeichnet,**

daß die weiteren Kontakte (5) an die Metallbelegung (31) anstoßend ausgebildet sind und diese Metallbelegung (31) längs eines parallel zu den Stegen (13,14) zwischen diesen verlaufenden Streifens unterbrochen ist (Figuren 7 und 8).

6. Halbleiterlaser nach einem der Ansprüche 1 bis 3,

**dadurch gekennzeichnet,**

daß außer den jeweiligen Längen $(L_1, L_2, L_3)$ der Bereiche lateraler Verkopplung auch die jeweiligen Längen (L) und Breiten $(s_1, s_2)$ der laseraktiven Streifen (11,12) und deren relative Abstände (a) für die vorgegebenen Resonatoreigenschaften bemessen sind.

## FIG 1

## FIG 2

## FIG 3

# FIG 4

# FIG 5

# FIG 6

## FIG 7

## FIG 8